Europäisches Patentamt

(19) European Patent Office

Office européen des brevets

(11) Publication number: **0 058 726**
**A1**

## (12) EUROPEAN PATENT APPLICATION

published in accordance with Art. 158(3) EPC

(21) Application number: **81902449.8**

(51) Int. Cl.³: **G 11 C 11/14,** G 11 C 19/08

(22) Date of filing: **01.09.81**

Data of the international application taken as a basis:

(86) International application number:
**PCT/JP 81/00208**

(87) International publication number:
**WO 82/00916 (18.03.82 82/8)**

(30) Priority: **01.09.80 JP 120783/80**
**01.09.80 JP 120784/80**

(71) Applicant: **FUJITSU FANUC LIMITED, 5-1, Asahigaoka, 3-chome, Hino-shi, Tokyo 191 (JP)**

(72) Inventor: **NOZAWA, Ryoichiro, 12-1-2105, Sarugaku-cho, Shibuya-ku Tokyo 150 (JP)**
Inventor: **KIYA, Nobuyuki, Yokokawa-cho-jutaku 13-106, 108 Yokohawa-cho, Hachioji-shi Tokyo 193 (JP)**

(43) Date of publication of application: **01.09.82**
**Bulletin 82/35**

(74) Representative: **Billington, Lawrence Emlyn et al, Haseltine Lake & Co. 9 Park Square, Leeds LS1 2LH (GB)**

(84) Designated Contracting States: **CH DE FR GB LI**

(54) **BUBBLE-CASSETTE MEMORY CONTROL METHOD AND DEVICE.**

(57) Bubble-cassette memory (12) control method and device wherein, when writing data into the bubble-cassette memory (12), each file of data is divided into a plurality of blocks (BH, BI,.....BE), a control-byte (CB), is inserted at the leading position of each block, a control information is written in each control-byte, a control-information is written on each control-byte indicatin if the block belonging to that control-byte is the lead block (BH) of a file, the data is sorted in the bubble-cassette memory (12) in the units of one block, and, in addition, a data-end block (DEB) is written after the final file (Fn). This controlling method and device make it possible to search a desired file while monitoring the content of the control-information and to search a position for writing a new file.

DESCRIPTION

METHOD AND APPARATUS FOR CONTROLLING

BUBBLE CASSETTE MEMORY

Technical Field

This invention relates to a method and apparatus for controlling a bubble cassette memory, in which the search for a desired file and the writing of a new file are facilitated by dividing one file of data into a plurality of blocks, inserting a control byte at the beginning of each block, writing control information into each control byte for distinguishing whether the block to which the control byte belongs is the head block, intermediate block or last block of the file, and inserting a data end block after the last file.

Background Art

In numerical control devices which incorporate a memory for storing a part program, it is conventional practice to use a paper tape as a storage medium for writing the part program into the self-contained memory and for preserving the information which is stored in the memory. Data is transferred from the paper tape to the built-in memory and from the built-in memory to the paper tape by a paper tape reader and paper tape puncher which are connected to the numerical control device.

A system of this type that relies upon a paper tape as the storage medium is not always satisfactory since the paper tape has a short life, is difficult to handle, diminishes reliability because of reading errors, and requires the costly paper tape reader and puncher, etc.

In recent years it has become possible to employ a

- 1 -

bubble cassette memory as a storage medium to replace the paper tape, and numerical control systems which adopt the bubble cassette memory as the storage medium have been proposed and put into use.

In the conventional system which adopts the bubble cassette memory as the storage medium, however, searching for an arbitrary machining program and controlling the readout thereof cannot be performed in simple fashion, nor can he search for a location to write in a new machining program. Moreover, it has not been possible to effectively exploit the memory area in the bubble cassette memory.

Accordingly, the object of the present invention is to provide a bubble cassette memory control method and apparatus in which the search for any machining program and for a location to write in a new machining program can be carried out in a simple manner, and in which effective utilization can be made of the memory area.

Disclosure of Invention

In the present invention, one input or one output unit (one file) of machining data for a bubble cassette memory is divided into a plurality of blocks, a control byte is inserted at the beginning of each block, and information is written into each control byte for distinguishing among a head block, intermediate block and last block. The search for a desired file consequently can be carried out in simple fashion. For example, a numerical control device or the like, merely by issuing an instruction indicative of the i-th file, causes the head blocks to be counted from the beginning of the bubble cassette memory until the count reaches the number "i", whereby the search for the desired

- 2 -

0058726

i-th file can be carried out in a simple manner.

Since the control data is deleted automatically in the transfer of data from the bubble cassette memory to the numerical control device or the like, the input and output of data can be carried out in the same manner as with an ordinary input/output unit without it being required that the numerical control device give special consideration to inputs and outputs with respect to the cassette memory.

Further, since one byte of control data is appended to each block, very fine control can be effected, beginning with the search for the abovementioned file, by entering prescribed control information in the control byte beforehand.

In addition, since a data end block is appended after the last file, the location into which a new file may be written can be found easily by retrieving the date end block at the time the new file is to be written. Moreover, this permits files to be stored consecutively without blank spaces intervening between files, so that the memory can be utilized effectively.

Brief Description of Drawings:

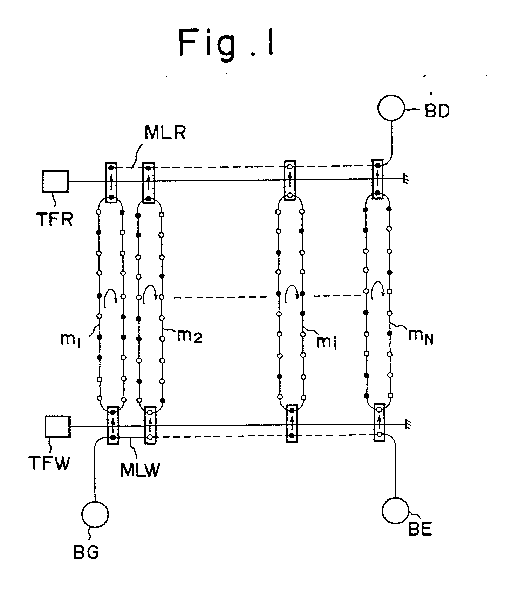

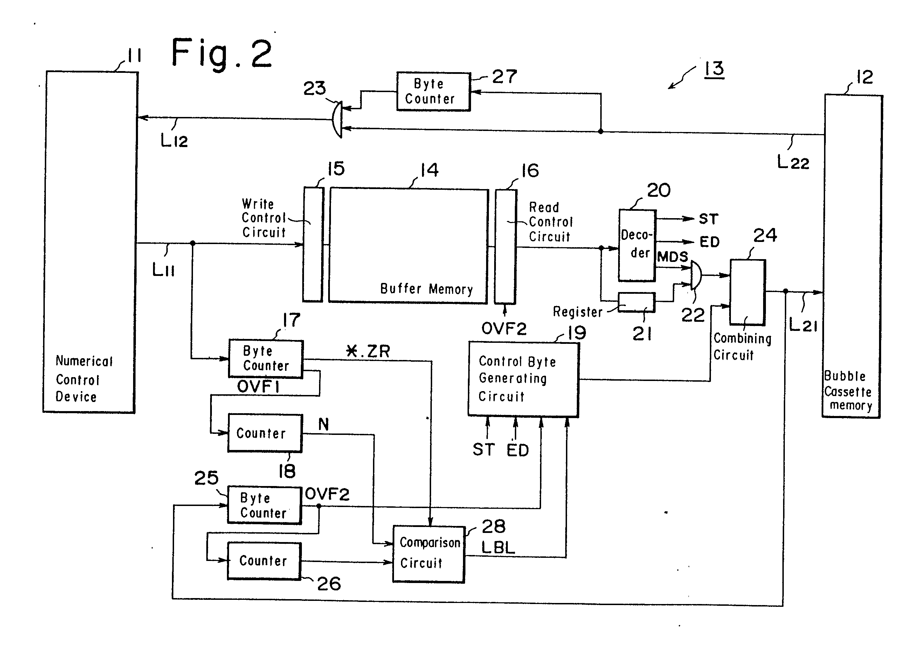

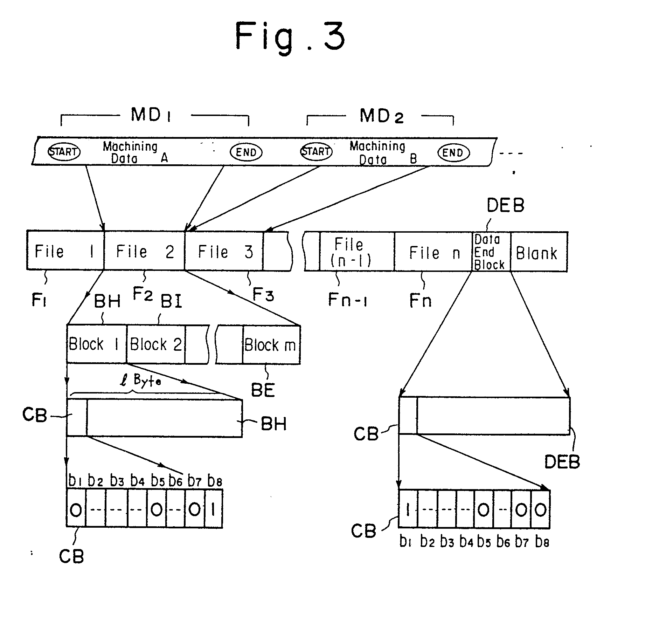

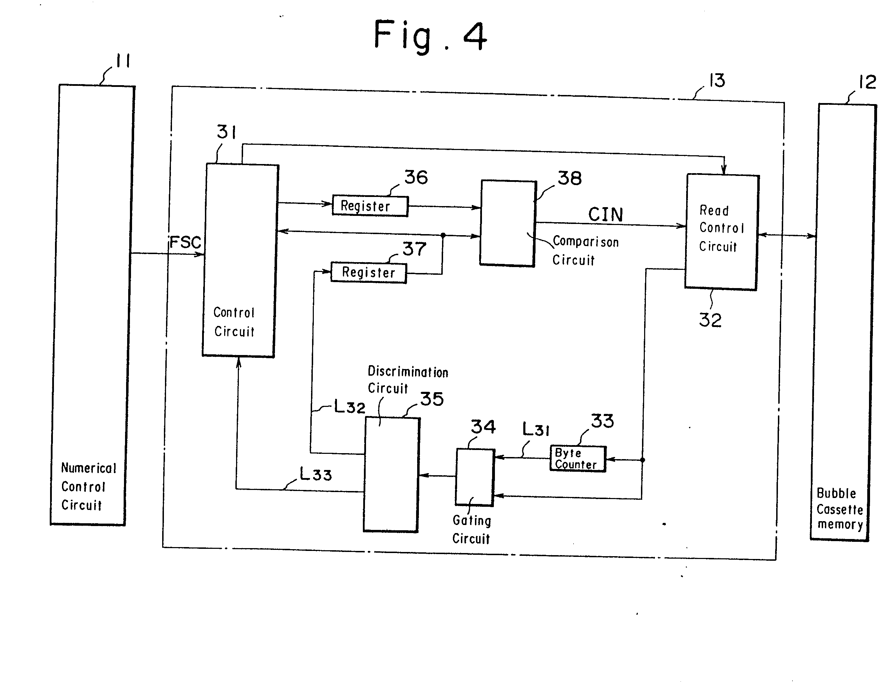

Fig. 1 is an illustrative view for describing the reading of information in a magnetic bubble memory of a major-minor loop configuration; Fig. 2 is a block diagram of a bubble cassette memory control apparatus which executes processing for storing data in a bubble cassette memory; Fig. 3 is a diagram showing the organization of data; and Fig. 4 is a block diagram of a bubble cassette memory control apparatus which executes processing for the search of

- 3 -

a predetermined file.

Best Mode for Carrying Out the Invention:

The present invention will now be described in greater detail in accordance with the accompanying drawings.

Fig. 1 is an illustrative view for describing the reading of information in a bubble cassette memory of a major-minor loop configuration.

In Fig. 1, $m_1$, $m_2$, $m_3$... $m_N$ denote minor loops which are a total of N in number. Each minor loop is constructed as a closed loop based on a bubble domain transfer track of 2M bits and may, by way of example, consist of a continuous series of T-bar patterns. BG represents a bubble generator, BE a bubble erasor, MLR a read-only major line, and MLW a write-only major line. One end of each of the minor loops $m_1$, $m_2$,..., $m_N$ adjoins the major line MLR, and the other end thereof adjoins the minor line MLW. In response to a transfer command from at transfer TFR, those bubble domains (the black circles in the diagram) in the minor loops $m_1$, $m_2$...$m_N$ which are at that instant in the positions adjoining the read-only major line MLR, are transferred to the read-only major line MLR. Furthermore, in response to a transfer command from a transfer TFW, those bubble domains (the black circles in the diagram) which have been written into the write-only major line MLW are transferred to the minor loops $m_1$, $m_2$...$m_N$ at the positions adjoining the major line MLW.

Read processing will be described next.

In reading one access unit of stored information comprising N bits, the first step is to transfer, in parallel fashion, the bubble domains in the N-number of minor loops

$m_1$, $m_2$,.....$m_N$ to the read-only major line MLR by means of a transfer command. In the magnetic bubble memory of Fig. 1, if we let the information of 2M bits stored in each minor loop $m_i$ (i=1, 2,... N) be expressed by b(i,1), b(i,2),..., b(i,2M-1), b(i, 2M), then one access unit of stored information will mean N-bit information combrising the bits [b(1,j), b(2,j),....., b(N,j)], where j = 1, 2,...., 2M. One access unit of stored information will be referred to as a block hereinafter.

Next, the bubble domains which have been transferred to the read-only major line MLR are shifted bit-by-bit successively within the major line MLR and are output serially. Accordingly, when a bubble detector BD such as one which relies upon magneto-resistance is provided at the exit from the read-only major line MLR, the absence or presence of bubble domains may be sensed by the detector BD to effect the read operation. It should be noted that, in a read operation, the bubble domains of one access unit in the minor loops $m_1$, $m_2$, ..., $m_N$ may be read destructively so as to erase them, or non-destructively so as not to erase them. In the customary read operation a non-destructive read is performed.

Accordingly, stored information is read from the read-only major line MLR, and data is written from the write-only major line MLW. The bubble domains are shifted within each of the minor loops $m_i$ in the directions of the arrows, and a prescribed single access unit of information is read when the access unit of information arrives at the read-only major line MLR, or data is written when the bubble domains into which the data is to be written arrive at the

- 5 -

write-only major line MLW.

Consequently, in reading data out of the magnetic bubble memory, the data must be brought to the positions adjacent MLR and, in writing the data, said data must be brought to where it is adjacent MLW.

Fig. 2 is a block diagram of a bubble cassette memory control apparatus which executes processing for storing data in a cassette memory, and Fig. 3 is an illustrative view for describing data organization.

In Fig. 2, numeral 11 denotes a numerical control device, 12 a bubble cassette memory comprising a magnetic bubble memory, and 13 a bubble cassette memory control apparatus for writing data into the bubble cassette memory 12, for reading data out of the bubble cassette memory, and for controlling the transfer of data between the numerical control device 11 and the cassette memory 12.

Numeral 14 denotes a buffer memory for temporarily storing a series of machining data of one input or one output unit (referred to as one file), such as a machining program, produced continuously by the numerical control device 11. In Fig. 3, one file of machining data, represented by $MD_i$ (i=1, 2,...), is composed of a start byte, a number of machining program bytes, and an end byte. Numeral 17 denotes a byte counter having a capacity of $\ell-1$, when one block is assumed to consist of $\ell$ bytes. Byte counter 17 counts up, byte-by-byte, the machining data delivered by the numerical control device 11, and produces a signal *ZR (="1") when its content is non-zero. Numeral 18 denotes a counter for counting overflow pulses $OVF_1$ generated by the byte counter 17. When *ZR = "0", the value of the count N in counter 18

- 6 -

represents the number of blocks in one file, as will be described below; when *ZR = "1", N+1 represents the number of blocks in one file. Numeral 19 designates a control byte generating circuit which, when one file of machining data $MD_i$ is divided into a number of blocks $\ell-1$ bytes each, is operable to insert a control byte CB (Fig. 3) of one byte at the beginning of each block. The file of machining data $MD_i$ then is stored in the cassette memory 12. As shown in Fig. 3, the control byte CB is composed of eight bits $b_1$ through $b_8$. In one file, a "1" is stored in the control byte (eighth bit $b_8$) of the head block BH, in the control byte (fifth bit $b_5$) of the end block BE, and in the control byte (seventh bit $b_7$) of the intermediate blocks BI. Further, although a multiplicity of files $F_i$ (i=1, 2,....) are stored in the bubble cassette memory 12, a data end blocks DEB is written into the cassette memory after the last file $F_n$. Also, a "1" is written into the first bit $b_1$ of the control byte CB in the data end block. Thus, a file will be stored in the bubble cassette memory 12 with a "1" written in the eighth bit $b_8$ of a control byte if the block is the head block of the file, in the fifth bit $b_5$, if the block is the end block of the file, in the seventh bit $b_7$ if the block is an intermediate block of the file, and in the first bit $b_1$ if the block is a data end block.

Numeral 20 denotes a decoder which generates a data start signal (="1") when the data read out of the buffer memory 14 is start data START, a data end signal ED (="1") when the data read out is end data END, and a machining data signal MDS (="1") when the data read out is neither the start data nor the end data. Reference numeral 21 denotes

- 7 -

a one-byte register, 22 and 23 denote AND gates, and 24 denotes a combining circuit for combining the machining data and the control data. Numeral 25 denotes a byte counter having a capacity $\ell$, the counter being counted up by +1 each time one byte of data is produced by the combining circuit 24. Numeral 26 denotes a counter which counts overflow pulses $OVF_2$ generated by the byte counter 25, and which indicates the number of blocks in one file. Numeral 27 denotes a byte counter having a capacity $\underline{\ell}$. Byte counter 27 counts, byte-by-byte, the data which is read out of the cassette memory 12, and produces a "1" when its content is non-zero. Numeral 28 represents a comaparison circuit.

The operation of Fig. 2 will be described next. We shall assume that the total number of blocks in one file is N+1, and that signal *ZR = 1 when one file of machining data has been stored in buffer memory 14.

Described first will be a case where one file of machining data $MD_1$ from the numerical control device 11 is stored in the bubble cassette memory 12.

When the machining data $MD_1$ is delivered successively byte-by-byte over line $L_{11}$, the machining data is stored in the buffer memory 14 under the control of a write control circuit 15. Concurrently, the byte counter 17 is counted up by one step each time one byte of machining data (exclusive of the start data and end data) is delivered on line $L_{11}$, and produces an overflow pulse $OVF_1$ upon the generation $\ell-1$ bytes of the machining data. The counter 18 counts the number of overflow pulses $OVF_1$ to indicate the number of blocks in the file. More specifically, when the content of byte counter 17 at the instant that the end byte is generated is zero (*ZR = "0"), the value of the count N in counter 18 will be the total number of blocks in the file; when *ZR = "1" at said instant, N+1 will be the total number of blocks in the file.

After all of the machining data in one file has been stored in the buffer memroy 14, the machining data is read out of the buffer register 14 successively byte-by-byte under the control of a read control circuit 16 and stored in the register 21, and is simultaneously applied to the decoder 20. Since the first item of data is start data START, the data start signal ST ("1") is produced by the decoder 20, whereas the machining data signal MDS and data end signal ED are "0". In consequence, AND gate 22 closes, so that the start data cannot be delivered to the combining circuit 24. Meanwhile, the control byte generating circuit 19, owing to the fact that the data start signal ST is a "1", generates the control data having the "1" written in the eighth bit, the control data being applied to the bubble cassette memory through the combining circuit 24 and line $L_{21}$ and written into the bubble cassette memory. Since the data which follows the start data START is the machining data, the decoder 20 thereafter producds the machining data signal MDS (="1") until the data end signal END is produced. As a result, $\ell-1$ bytes of the machining data are stored in the cassette memory 12 through the AND gate 22, combining circuit 24 and line $L_{21}$. (Writing of head block BH accomplished.)

The byte counter 25 is counted up by one step each time one byte of data is produced by the combining circuit 24. Accordingly, when the combining circuit 24 delivers one byte of control data and $\ell$-1 bytes of machining data, or in other words, when the combining circuit 24 delivers $\underline{\ell}$ bytes (one block) of data, byte counter 25 generates an overflow pulse $OVF_2$. This counts up counter 26 by one step, and causes the read control circuit 16 to temporarily halt the reading of data from the buffer memory 14. The control byte generating circuit 19, meanwhile, owing to the generation of the overflow pulse $OVF_2$, produces the control data having the "1" written in the seventh bit $b_7$, which control data is written into cassette memory 12 through the combining circuit 24 and line $L_{21}$. Next, the read control circuit 16 again reads $\ell$-1 bytes of machining data out of the buffer memory 14. This data is stored in the bubble cassette memory 12 through the AND gate 22, combining circuit 24 and line $L_{21}$. (Writing of second block accomplished.)

Thereafter, the control data having the "1" written in the seventh bit thereof is inserted and written into the cassette memory 12 even $\ell$-1 bytes of machining data, just as described above.

The count in counter 26 assumes the value N at the instant that the block immediately preceding the end block BE of a single file is written into the cassette memory 12. The value of the count in counter 18 is N since the assumption is that the content of byte counter 17 is non-zero ($*ZR="1"$), the total number of blocks being N+1. Accordingly, at the point in time that the block immediately preceding the end block BE is written into the cassette memory 12, the contents of counters 18, 26 are both N, so that the comparison circuit produces a coincidence signal LBL ($="1"$). In consequence, the control byte generating circuit 19 generates the control data having the "1" written in the fifth bit $b_5$, which control data is stored in the cassette memory 12 through the combining circuit 24 and line $L_{21}$. The machining data of the end block BE is then stored in the bubble cassette memory 12 through the AND gate 22, combining circuit 24 and line $L_{21}$.

When end data END is read out of the buffer memory 14, the decoder 20 produces the end data signal ED (="1"). In response to the generation of the end data signal ED, AND gate 22 is closed and the control byte generating circuit 19 generates the one-byte control data having the "1" written in the first bit $b_1$, which data is stored in the cassette memory 12. (Writing of data end block DEB accomplished.)

Thus, owing to the foregoing operation, one file of machining data is divided into individual blocks and one byte of control data is inserted at the beginning of each block before the machining data is stored in the bubble cassette memory 12. In addition, a data end block DEB is written after the most recent file. Note that in a case where a subsequent file is to be written into the cassette memroy 12, said file is stored starting from the location occupied by the stored data end block, and then is followed by storage of the data end block.

Described next will be a case where one file of machining data is read out of the cassette memory 12 and transmitted to the numerical control device.

Since the content of $\ell$-capacity byte counter 27 will initially have been cleared to zero, AND gate 23 will be closed. Then, one file of machining data is read out of

- 11 -

bubble cassette memory 12 over line $L_{22}$ in the sequence one byte of control data, $\ell-1$ bytes of machining data, one byte of control data, $\ell-1$ bytes of machining data, and so on.

At the point in time that the control data is read out, therefore, AND gate 23 is closed since the content of byte counter 27 is zero, so that the control data cannot be delivered to the numerical control device 11. On the other hand, when the $\ell-1$ bytes of machining data are read out, AND gate 23 is open since the content of the byte counter 27 ranges from 1 to $\ell-1$, so that the machining data is delivered to the numerical control device 11. In summation, therefore, the data read out of the bubble cassette memory 12 is sent to the numerical control device 11 following removal of the control data.

Fig. 4 is an illustrative view for describing a method searching for a prescribed file. Portions identical to those shown in Fig. 2 are denoted by like reference characters. In addition, some portions of Fig. 2 are deleted.

In Fig. 4, numeral 31 denotes a control circuit which controls file search in response to a file search command FSC issued by the numerical control device 11. Numeral 32 denotes a read control circuit which controls the reading of data with respect to the bubble cassette memory 12 in response to signals from the control circuit 31 and from a comparator, to be described below. Numeral 33 denotes a byte counter having a capacity of $\ell$ bytes. Byte counter 33 is counted up by one step each time one byte of data is read out of the bubble cassette memory 12 through the read control circuit 32, and issues a "1" on line $L_{31}$ when its content is zero, and a "0" at all other times. The content of byte counter 33 becomes zero each time $\ell$-bytes of data are read out. In other words, the content of byte counter 33 reaches zero, so that a "1" appears on line $L_{31}$, when the head byte (control byte) of each block is read. Numeral 34 denotes a gating circuit which opens when the content of byte counter 33 is zero, and which is closed when the content is non-zero. Thus, gating circuit 34 delivers solely the control data. Numeral 35 denotes a discrimination circuit which delivers a "1" on line $L_{32}$ if a "1" is located in the eighth bit of the control byte, or a "1" on line $L_{33}$ if a "1" is located in the first bit of the control byte. That is, the discrimination circuit 35 examines the control data which arrives through the gating circuit 34 and delivers a "1" on line $L_{32}$ when the head block BH of a file is read, or on line $L_{33}$ when the data end block DEB is read. Numeral 36 represents a commanded file location register for storing the location of the file which is to be searched (where "location" is taken to mean the ordinal number of the file from the head file). For example, when the numerical control device 11 issues a file search command FSC instructing that the i-th file be searched, the numerical value $i$ is stored in the commanded file location register 36. If a file search FSC is issued calling for the search of the file $F_{i+1}$ which follows the file input or output immediately prior thereto, then the control circuit 31 performs the operation "(immediately preceding input or output file location $i$) + (1)", and stores the result of the calculation, namely "i+1", in the commanded file location register 36. Numeral 37 denotes a file current location register which is counted up by one step each time a "1"is produced on line $L_{32}$, thereby storing the location of the file which is currently being read. Numeral 38 denotes a comparison circuit which delivers a coincidence signal CIN (="1") to the read control circuit 32 when the commanded file location and the current file location coincide.

The operation of the present invention will be described next.

When the numerical control device 11 issues a search command FSC calling for the search of a file having a commanded file location $\underline{i}$, the latter is set in the commanded file location register 36 under the control of the control circuit 31. The control circuit 31 concurrently sends a read command to the read control circuit 32 in order to read data from the beginning of the cassette memory 12. The read control circuit 32 responds by reading data from the head file. Byte counter 33 will issue a "1" on line $L_{31}$, its content being zero only when the initial byte of a block is read. Accordingly, only the control data is applied to the discrimination circuit 35 through gating circuit 34. The discrimination circuit 35 issues a "1" on line $L_{32}$ each time it receives control data having "1" written in the eighth bit $b_8$, each "1" output counting up the content of file current location register 37 by one step. Thereafter, and in similar fashion, a "1" will appear on line $L_{32}$ each time the control data of a head block is read, and the content of the file current location register 37 will be counted up by one step each time.

The comparison circuit 38, meanwhile, compares the commanded file location $\underline{i}$ with the file current location and delivers the coincidence signal CIN to the read control circuit 32 when coincidence is achieved. The read control circuit 32 halts the read operation upon receiving the coincidence signal, thereby ending the commanded file search.

Further, if the numerical control device issues a search command for the file which follows the file input or output immediately prior thereto, the control circuit performs the operation"i+1"and sets i+1 in the commanded file location register 36, after which the file is searched through an operation similar to that set forth above.

In writing in a new file, the numerical control device issues a data end block search command as the command FSC. When the search command FSC for the data end block DEB is provided, data is read out of the bubble cassette memory 12 as described above. When the discrimination circuit 35 detects the control data having the "1" written in the first bit $b_1$, it produces a "1"on line $L_{33}$. In response, control circuit 31 instructs the control circuit 32 to halt the read operation, thereby ending the search for the data end block. The new file is written starting from the location at which the data end block is written.

Industrial Applicability

Accordingly, as set forth hereinabove, the present invention divides one file of data into a plurality of blocks, inserts a control byte at the beginning of each block, writes control information into each control byte for distinguishing whether the block to which the control byte belongs is the head block of the file, and inserts a data end block after the last file and stores it in the bubble cassette memory.  The present invention therefore makes it possible to search for a desired file and to search for a location into which new data may be written, etc.

Thus the invention is well suited for application to the external storage medium of a numerical control device, by

way of example.

WHAT IS CLAIMED IS:

1.     A method of controlling a bubble cassette memory in a system equipped with a numerical control device, a bubble cassette memory, and a memory control device provided between said numerical control device and bubble cassette memory for writing data into the bubble cassette memory and for reading data out of the bubble cassette memory, characterized by including the steps of dividing a file into a plurality of sub-data groups comprising a predetermined number of bytes, when a data group of one input unit sent from said numerical control device to the memory device is taken as one file, inserting a control byte at the beginning of each sub-data group, the control byte and sub-data group constituting one block, and storing data in the bubble cassette memory in one block units.

2.     A method of controlling a bubble cassette memory according to claim 1, characterized by including the steps of discriminating whether a block to which said control byte belongs is the head block of a file, and writing, into each control byte, control information which indicates whether the block to which said control byte belongs is the head block of a file.

3.     A method of controlling a bubble cassette memory according to claim 2, characterized by including the steps of storing successively a plurality of files in the bubble cassette memory, appending a data end block after the last file stored in said bubble cassette memory, and writing data end information into the control byte of said data end block.

4.     A method of controlling a bubble cassette memory according to claim 2, characterized by including the steps of generating a file search command, and searching for the file designated by said search command, using said control information.

5.     A method of controlling a bubble cassette memory according to claim 2, characterized by including the steps of storing successively a plurality of files in the bubble cassette memory, generating a file search command which includes  file location information indicating the ordinal number of the file. from the head file, reading out data block-by-block from the beginning of the bubble cassette memory, discriminating and counting head blocks, using the control information of each block, for computing the current file location, and searching for the commanded file upon comparing the current file location and the commanded file location.

6.     A method of controlling a bubble cassette memory according to claim 1 or claim 2, characterized by including the step of transmitting data read out of said bubble cassette memory to the numerical control device following deletion of the control byte.

7.     A bubble cassette memory control apparatus for controlling the writing of data into a bubble cassette memory and the reading of data out of the bubble cassette memory, characterized by including means for dividing a file into a plurality of sub-data groups comprising a predetermined number of bytes, and for inserting a control byte at the beginning of each sub-data group, when a data group of one input unit is taken as a file, means for discriminating whether a block comprising one control byte and one sub-data group is the head block of a file, means for writing, into each control byte, control information which indicates whether the block to which said control byte belongs is the head block of a file, and means for storing data in the bubble cassette memory in one block units.

8.    A bubble cassette memory control apparatus according to claim 7, characterized by including means for inserting a data end block after the last file, and for writing data end information into the control byte of said data end block.

9.    A bubble cassette memory control apparatus according to claim 7, characterized by including means for generating a file search command which includes file location information indicating the ordinal number of the file from the head file, means for reading out data block-by-block from the beginning of the bubble cassette memory, means for discriminating head blocks using the control information, means counted up each time a head block is discriminated for storing the current file location, and means for comparing the current file location and the commanded file location, whereby the commanded file is searched.

# Fig. 1

Fig.2

# Fig.3

# Fig. 4

# INTERNATIONAL SEARCH REPORT

International Application No  PCT/JP81/00208

**I. CLASSIFICATION OF SUBJECT MATTER (if several classification symbols apply, Indicate all)** [3]

According to International Patent Classification (IPC) or to both National Classification and IPC

Int. Cl.[3] G11C 11/14, G11C 19/08

**II. FIELDS SEARCHED**

| Minimum Documentation Searched [4] | |
|---|---|
| Classification System | Classification Symbols |
| I P C | G11C 11/14, G11C 19/08 |

| Documentation Searched other than Minimum Documentation to the Extent that such Documents are Included in the Fields Searched [5] |
|---|
| Jitsuyo Shinan Koho          (before 1981) |

**III. DOCUMENTS CONSIDERED TO BE RELEVANT** [14]

| Category [*] | Citation of Document, [16] with indication, where appropriate, of the relevant passages [17] | | Relevant to Claim No. [18] |
|---|---|---|---|
| A | JP, A, 49-114329<br>N.V. Philips' Gloeilampenfabrieken | 1974-10-31 | 1 - 9 |
| A | JP, U, 52-010735<br>Hitachi, Ltd. | 1977-01-25 | 1 - 9 |
| A | JP, A, 52-009330<br>Hitachi, Ltd. | 1977-01-24 | 1 - 9 |
| A | JP, A, 52-016138<br>Hitachi, Ltd. | 1977-02-07 | 1 - 9 |
| A | JP, A, 52-031626<br>Hitachi, Ltd. | 1977-03-10 | 1 - 9 |
| A | JP, A, 53-063823<br>Hitachi, Ltd. | 1978-06-07 | 1 - 9 |

\* Special categories of cited documents: [15]

"A" document defining the general state of the art

"E" earlier document but published on or after the international filing date

"L" document cited for special reason other than those referred to in the other categories

"O" document referring to an oral disclosure, use, exhibition or other means

"P" document published prior to the international filing date but on or after the priority date claimed

"T" later document published on or after the international filing date or priority date and not in conflict with the application, but cited to understand the principle or theory underlying the invention

"X" document of particular relevance

**IV. CERTIFICATION**

| Date of the Actual Completion of the International Search [3] | Date of Mailing of this International Search Report [3] |
|---|---|
| October 22, 1981 (22.10.81) | November 2, 1981 (02.11.81) |
| International Searching Authority [1] | Signature of Authorized Officer [10] |
| Japanese Patent Office | |

Form PCT/ISA/210 (second sheet) (October 1977)

0058726

| FURTHER INFORMATION CONTINUED FROM THE SECOND SHEET | | | |
|---|---|---|---|
| A | JP, A, 53-067324 <br> Hitachi, Ltd. | 1978-06-15 | 1 - 9 |
| A | JP, A, 53-139948 <br> FUJITSU LIMITED | 1978-12-06 | 1 - 9 |
| A | JP, U, 52-060974 <br> FUJITSU LIMITED | 1978-12-06 | 1 - 9 |

**V.☐ OBSERVATIONS WHERE CERTAIN CLAIMS WERE FOUND UNSEARCHABLE** [10]

This international search report has not been established in respect of certain claims under Article 17(2) (a) for the following reasons:

1.☐ Claim numbers _____, because they relate to subject matter [13] not required to be searched by this Authority, namely:

2.☐ Claim numbers _____, because they relate to parts of the international application that do not comply with the prescribed require-ments to such an extent that no meaningful international search can be carried out [13], specifically:

**VI.☐ OBSERVATIONS WHERE UNITY OF INVENTION IS LACKING** [11]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

Remark on Protest

☐ The additional search fees were accompanied by applicant's protest.

☐ No protest accompanied the payment of additional search fees.

Form PCT/ISA/210 (supplemental sheet (2)) (October 1977)